# EUROPEAN PATENT APPLICATION

(11) **EP 1 973 159 A2**
(43) Date of publication of application: **24.09.2008**
(21) Application number: 08102857.3
(22) Date of filing: 21.03.2008
(51) Int. Cl.: H01L 23/522

(54) **Integrated resistor capacitator structure**

(30) Priority: 23.03.2007 US 690379
(71) Applicant: Honeywell International Inc., Morristown, NJ 07962 (US)
(72) Inventor: Fechner, Paul S., Plymouth, MN 55447 (US); Shaw, Gordon A., Plymouth, MN 55446 (US)
(74) Representative: Buckley, Guy Julian

(57) **Abstract**

A resistor capacitor structure and a method of fabrication. A resistor capacitor structure provides a capacitance between at least two nodes within a microelectronic circuit. A bottom plate of the resistor capacitor structure comprises a resistance layer, which in turn provides a resistance path between an additional node within the circuit. The resistor capacitor structure may be formed on top or within interlevel dielectric layers. The resistance layer, alternatively, may be used to fill a cavity located between iiiterlevel dielectric layers and accordingly provide a resistance path between the interlevel dielectric layers.

## Description

### FIELD

The invention relates to microelectronic devices and semiconductor fabrication, and more particularly to resistive and capacitive structures within interlevel dielectric layers that may be formed during back-end processing.

### BACKGROUND

In aerospace and space environments, microelectronic circuits are exposed to increased levels of radiation relative to the levels of radiation that they would be exposed to at lower altitudes. The increased level of radiation causes transient changes in voltage states within a circuit, which in turn disrupts circuit operation. Often times, this disruption is detrimental to the operation of a conventional circuit. Thus, in higher altitude applications, microelectronics are often radiation "hardened" to ensure that circuit operation is not disrupted.

There are various methods of hardening microelectronics. One method is to create replicated components and to use a voting scheme that outputs a value that is associated with a majority output of the replicated components. Another method, which may be used in combination with the voting scheme, is to insert delay elements in the propagation path between critical circuit nodes. In operation, the delay elements allow the charge associated with the transient disruptions in voltage states to dissipate before it affects the voltage level of a critical circuit node. Typically, these delay elements comprise a combination of a resistor and a capacitor.

Although useful in mitigating radiation effects, delay elements create an area penalty in the layout of a microelectronic circuit. For example, resistors and capacitors formed within a substrate and alongside front-end devices may significantly increase the die-size of a chip.

To reduce this area penalty, delay elements may be formed within the interlevel dielectrics and the associated metal interconnect layers that electrically couple front-end devices together. An electrical contact may couple a front-end device to the resistor or capacitor. A via, on the other hand, may provide an electrical coupling between interlevel dielectric layers, allowing the resistor and capacitor to form a delay element structure. Examples of interlevel resistors and capacitors include Metal-Insulator-Metal (MIM) capacitors and metal resistors.

Even though such interlevel devices decrease area penalties, they also increase processing overhead and necessitate additional processing steps. For example, separate photolithographic patterning and etching steps are required to form a resistor and a capacitor.

Therefore, it is desirable to reduce the processing overhead and complexity of interlevel devices.

### SUMMARY

A resistor capacitor structure and a method of fabrication thereof are presented.

In one example, a resistor capacitor structure comprises a substrate, a first layer positioned on top of the substrate, and a second layer made from a dielectric material positioned on top of the first layer. The first layer, in operation, electrically couples a first electrical contact to a second electrical contact. Accordingly, the first layer serves as both a bottom plate and a resistive element of the resistor capacitor structure. Preferably, the first layer comprises a material having a sheet resistance of at least 5 kΩ/square.

A method for fabricating the resistor capacitor structure includes providing a substrate, depositing the first layer on the substrate so that a first electrical contact is coupled to a second electrical contact, and depositing a second layer made from a dielectric material on top of the first layer.

The example method may also include depositing a third layer made from a conductive material on top of the second layer. The third layer may serve as a top plate of the resistor capacitor structure.

In one example, the first layer may comprise Tantalum Nitride (TaN). The resistance of the TaN may be tailored by adjusting the nitrogen content in the TaN. The TaN may be deposited in a sputter deposition process and the nitrogen (N₂) partial pressure may be adapted to achieve a desired RC time constant associated with the resistor capacitor structure. Alternatively, in lieu of a sputter deposition process, a chemical vapor deposition (CVD) or other suitable process may be used to deposit TaN.

To form the resistor capacitor structure, in one example, the method may include depositing a photoresist layer and etching away a portion of the stack comprising the first and second layers. Because the TaN serves as a bottom plate of the resistor capacitor structure, patterning the photoresist layer and etching the stack may be carried out in a single photolithographic iteration.

In another example, the resistor capacitor structure may be created by forming a cavity in the substrate and depositing the first and second layers in the cavity.

To provide a delay between two nodes within a circuit, the resistor capacitor structure may be positioned adjacent to a microelectronic device. For example, the resistor capacitor structure may be coupled between the gates of two MOS devices.

In an alternative example, a method for fabricating a resistor structure is presented. The method includes providing a substrate that includes a first electrical contact and cavity, such that the cavity is positioned above the first electrical contact and using a sputter deposition process to line the cavity and the first electrical contact with a TaN layer.

In another example, a method for fabricating the resistor structure may further include depositing a first dielectric layer on top of the substrate and forming a second electrical contact within the first dielectric layer so that the second electrical contact is coupled with the TaN layer. In a further example, the cavity may be filled with a second dielectric material.

These as well as other aspects and advantages will become apparent to those of ordinary skill in the art by reading the following detailed description, with reference where appropriate to the accompanying drawings. Further, it is understood that this summary is merely an example and is not intended to limit the scope of the invention as claimed.

### BRIEF DESCRIPTION OF THE DRAWINGS

Certain examples are described below in conjunction with the appended drawing figures, wherein like reference numerals refer to like elements in the various figures, and wherein:
Figure 1A is a cross-section of an example resistor capacitor structure comprising a stack of layers deposited on top of a substrate;
Figure 1B is a cross-section of an example resistor capacitor structure comprising a stack of layers deposited within a cavity;
Figure 1C is an electrical schematic representation of the resistor capacitor structures of Figs. 1A-B;
Figures 2A-D are cross-sections that show the fabrication of the resistor capacitor structure of Fig. 1A, according to an example;
Figures 3A-D are cross-sections that show the fabrication of the resistor capacitor structure of Fig. 1B, according to an example;
Figure 4A is a cross-section of an example resistor structure;
Figure 4B is an electrical schematic representation of the resistor structure of Fig. 4A; and
Figures 5A-D are cross-section that show the fabrication of the resistor structure of Fig. 4A, according to an example.

### DETAILED DESCRIPTION

A resistor capacitor structure and a method of fabrication thereof are presented. The resistor capacitor structure provides a capacitance between at least two nodes as well as a resistance path between at least one additional node. To do this, the resistor capacitor structure includes a first layer that serves as both a bottom plate of a capacitor as well as a resistive element. The first layer may be sandwiched between a substrate and a second layer made from a dielectric material.

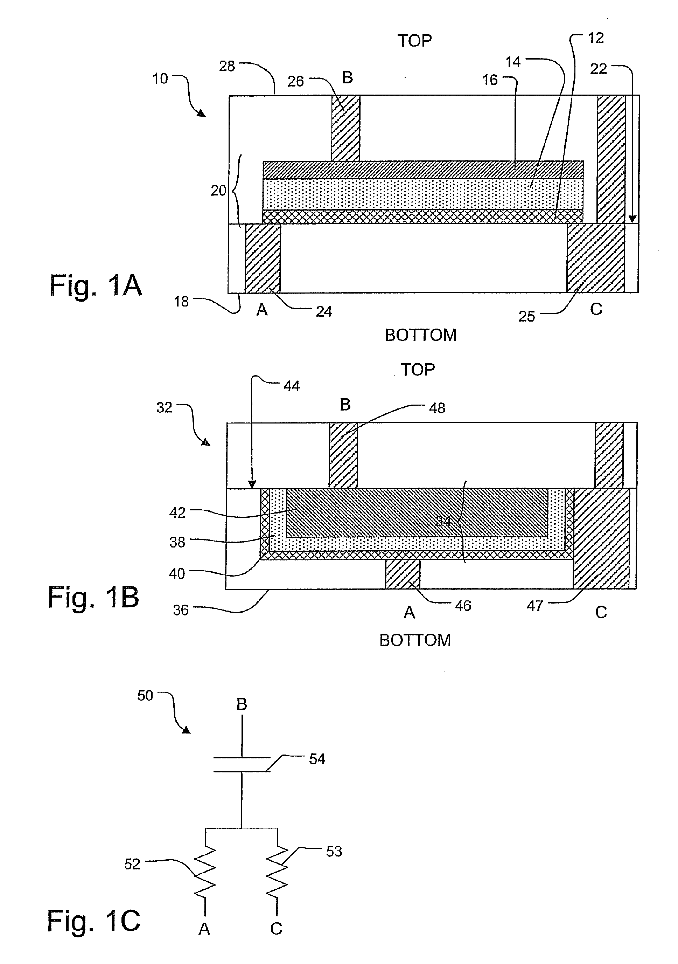

Turning now to the figures, Fig. 1A shows a resistor capacitor structure 10 that includes a first layer 12, a second layer 14, and a third layer 16. The second layer 14 comprises a dielectric material and is sandwiched between the bottom and top plates respectively provided by the first and third layers 12, 16. The first layer 12, which is positioned on top of a substrate 18, preferably comprises a material that has a sheet resistance of at least 5 kΩ/square. The third layer 16 preferably comprises a conductive material.

In Fig. 1A, the layers 12-16 form a stack 20, which is planer to a surface 22 of the substrate 18. The first layer 12 is electrically coupled to contacts 24-25, which are located within the substrate 18. The contacts 24-25, for example, may provide an electrical contact to microelectronic devices, such as MOS transistors. The third layer 16 is electrically coupled to a via 26. The via 26 along with the stack 20 are located within an interlevel dielectric layer 28. The via 26 may provide an electrical coupling between the stack 20 and a higher level metal layer located in a dielectric layer positioned above the dielectric layer 28. It should be understood that the stack 20 may be positioned in between any interlevel dielectric layer. In such a scenario, the contacts 24-25 could be vias that are coupled to a metal layer that is located below the substrate 18.

Fig. 1B, shows an alternative arrangement for a resistor capacitor structure 32. In this configuration the resistor capacitor structure 32 comprises a stack 34 that is formed within a cavity of a substrate 36. The stack includes a second layer 38 that is sandwiched between a first layer 40 and a third layer 42. The first and third layers 40-42 provide respective bottom and top plate couplings to the second layer 38. The first layer 40, which is parallel to a surface 44 of the substrate 36, preferably comprises a material that has a sheet resistance of at least 5 kΩ/square. The third layer 42 preferably comprises a conductive material. The second layer 38 comprises a dielectric material. Similar to the resistor capacitor structure 10, the first layer 40 may be coupled to contacts or vias located within the substrate 36 and the third layer 42 may be coupled to a via located within an interlevel dielectric layer 44. In Fig. 1B, the first layer couples contacts 46-47 together. The third layer is coupled to a via 48.

Fig. 1C shows a schematic representation of a resistor capacitor structure 50. Resistances 52-53 of the resistor capacitor structure 50 are established by a resistance layer, such as the first layers 12, 40. The resistances 52-53 provide a resistance path between the nodes A and C. This resistance layer also establishes a bottom plate connection of a capacitor 54, which in turn couples the nodes A and C to the node B.

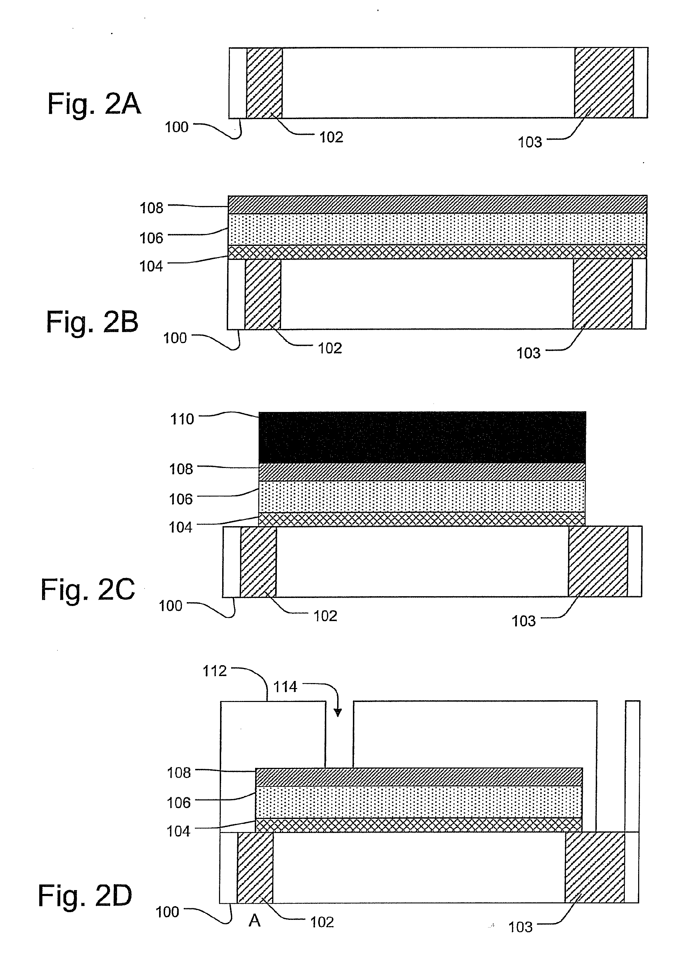

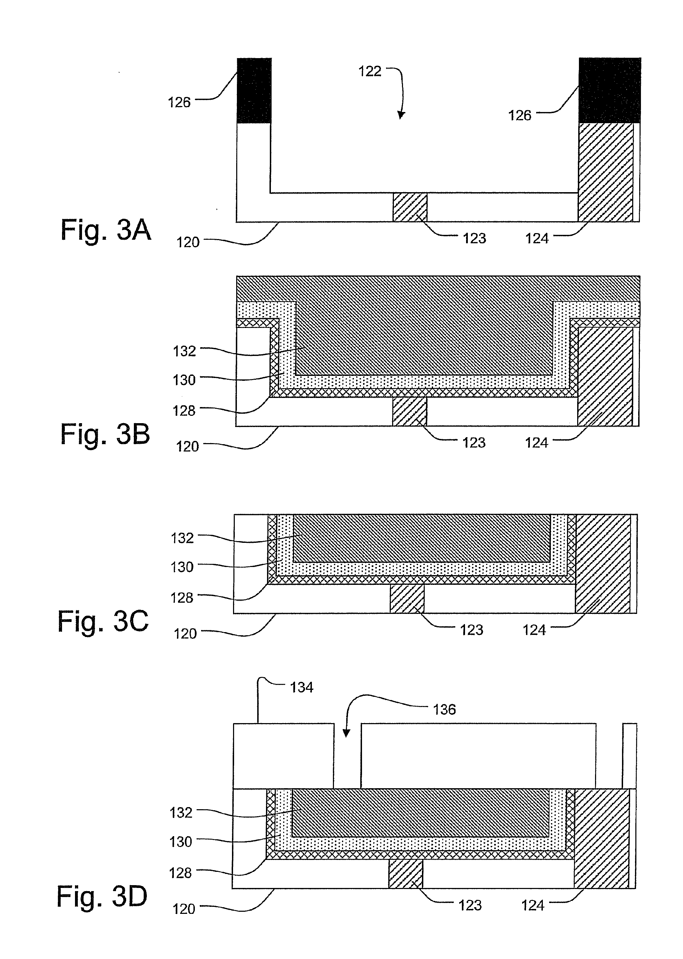

Figs. 2A-D and Figs. 3A-D are cross-sections that show the fabrication of a resistor capacitor structure. Figs. 2A-D show the fabrication of a resistor capacitor structure that comprises a stack of layers located on top of a substrate. Figs. 3A-D, on the other hand, show the fabrication of a resistor capacitor structure that is formed in a cavity.

Turning now to Fig. 2A, a substrate 100 is provided. The substrate 100 comprises contacts 102-103. The substrate 100 may comprise a field oxide or other type of dielectric material that provides electrical isolation between the contacts 102-103.

In Fig. 2B, a resistance layer 104, a dielectric layer 106, and a conductive layer 108 have been deposited on a top surface of the substrate 100. The resistance layer 104 electrically couples the contacts 102-103.

In one example, the resistance layer comprises Tantalum Nitride (TaN). TaN, which is typically used as a barrier layer in Copper interconnects, may be deposited in a physical deposition process (i.e., sputter deposition). To ensure that the resistance is at least 5k Ω/square, the nitrogen (N₂) partial pressure during the deposition should be about 25% or more. Table 1 shows the correlation between sheet resistance and the N₂ partial pressure for TaN films having a thickness of about 100 Angstroms. It is contemplated that for a larger sheet resistance of 100 k Ω/square or more, the N₂ partial pressure should be in the range of about 40 to 50%.

**Table 1**

| N₂ partial pressure in 5mtorr | Resitivity (k Ω/square) |
|---|---|
| 0.0% | .095 |
| 2.5% | .116 |
| 5.0% | .254 |
| 7.5% | .426 |
| 10% | .702 |
| 15% | 2.70 |
| 20% | 2.81 |
| 25% | 5.93 |
| 30% | 14.8 |

Other suitable materials for the resistance layer may include but are not limited to chrome silicon (CrSi) or aluminum silicon nitride (AlSiN).

The dielectric layer 106 may comprise a variety of materials which may include but are not limited to tantalum oxide (e.g., Ta₂O₅), silicon dioxide (SiO₂), and silicon nitride (SiN).

The metal conductive layer 108, which serves as the top plate of the resistor capacitor structure, may comprise metallic or semiconducting materials such as TiN or any other general conductive material.

In Fig. 2C, the layers 104-108 have been patterned and etched. A photoresist layer 110 has been deposited on top of the conductive layer 108 and patterned. The pattern in the photoresist layer 110 has been transferred into the layers 104-108 (e.g., by a plasma etch). Because the resistance layer 104 also serves as the bottom plate contact of the resistor capacitor structure, the resistor capacitor structure may be formed in a single photolithographic iteration that comprises one photolithographic step (i.e. photoresist deposition and exposure) and one etch.

After the layers 104-108 have been patterned, the photoresist layer 110 may be removed and the substrate 100 may undergo further back-end processing. Fig. 2D shows the layers 104-108 encapsulated in a dielectric film 112. The dielectric film 112 has been etched so that the conductive layer 108 is exposed. A subsequent via-fill process may fill an exposed portion 114 of the dielectric film 112.

Figs. 3A-D show the fabrication of a resistor capacitor structure in a cavity. Fig. 3A shows a substrate 120 comprising a cavity 122 and contacts 123-124. The substrate 120 may comprise a field oxide or other type of dielectric material that provides electrical isolation between the contacts 123-124. The cavity 122 has been created by a plasma etch, which has been established by a patterned photoresist layer 126.

In Fig. 3B, the photoresist layer 126 has been removed and the cavity 122 has been filled with a resistance layer 128, a dielectric layer 130, and a conductive layer 132. As described above, the resistance layer 128 may comprises, for example, TaN CrSi or AlSiN; the dielectric layer 130 may comprise tantalum oxide, SiO₂, and SiN; and, the conductive layer 132 may comprise TiN or tungsten (W), or TiN/W stack.

Fig. 3C shows the layers 128-132 after planarization. The planarization of the layers 128-132 isolates the dielectric layer and the top and bottom plates of the capacitor resistor structures from other devices and electrical interconnects that may be located within the substrate 120. The planarization, for example, may be carried out using a chemical and mechanical polish (CMP).

After the layers 128-132 have been planarized, the substrate 120 may undergo further back-end processing. Fig. 3D shows the layers 128-132 positioned below a dielectric film 134. The dielectric film 134 has been etched so that the conductive layer 132 is exposed. A subsequent via-fill process may fill an exposed portion 136 of the dielectric film 134.

In an alternative example, a resistance layer may be used to form a resistor structure. Such a structure may be located in an interlevel dielectric layer and may provide a resistance path between electrical contacts located on either side of the interlevel dielectric layer.

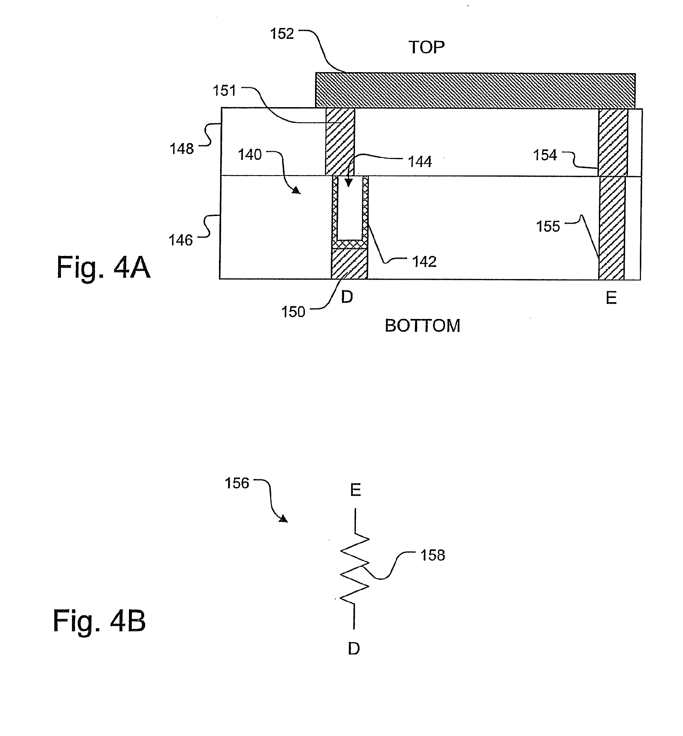

Fig. 4A shows a resistor structure 140. The resistor structure 140 includes a resistance layer 142 that lines a surface of a cavity 144. The remainder of the cavity 144 may be filled with a dielectric material. The cavity 144 is located within a substrate 146. The resistance layer 142 preferably has a sheet resistance of at least 5 kΩ/square. _A dielectric film 148 is located above the substrate 146. The substrate 146 and the dielectric film 148, for example, may comprise interlevel dielectric layers. However, other types of layers are possible. The resistance layer 144, in operation, provides an electrical coupling between electrical contacts 150-151, which are respectively located within the substrate 146 and the dielectric film 148. In one example, the resistance layer 142 comprises TaN. However, the resistance layer may comprise other materials, such as CrSi or AISiN. Note that the via 151 along with a metal layer 152 and contacts 154-155 may be used to couple a node of the resistance layer 144 to other devices below the dielectric film 148. In other implementations, a node of the resistance layer may be coupled to devices located above the dielectric film 148.

Fig. 4B shows a schematic representation of a resistor structure 156. A resistance layer provides a resistance 158 between two nodes, E and D.

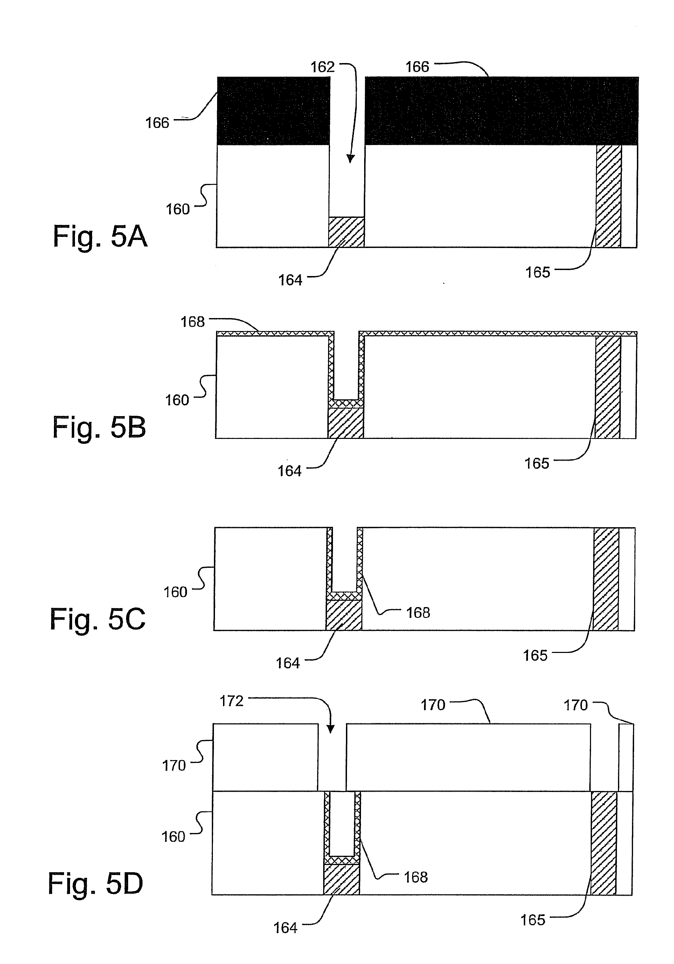

Figs. 5A-D are cross-sections that show fabrication of a resistor structure. Fig. 5A shows a substrate 160 comprising a cavity 162 and contacts 164-165. The substrate 160 may comprise a field oxide or other type of dielectric material that provides electrical isolation between the contacts 164-165. The cavity 162 has been created by a plasma etch, which has a pattern that is established by a patterned photoresist layer 166.

In Fig. 5B the photoresist layer 166 has been removed and the cavity 162 has been lined with a resistance layer 168.

Fig. 5C shows the resistance layer 168 after planarization or etch. The planarization or etch of the layers 168 isolates the resistance layer 168 from other devices and electrical interconnects that may be located within the substrate 160. The planarization, for example, may be carried out using CMP. Alternatively, the resistance layer 168 may be removed by using a plasma etch. A plasma etch, for example, may be designed to etch a top surface of the substrate 160 and leave the cavity 168 filled with a remaining amount of the resistance layer 168.

After the resistance layer 168 has been planarized or etched, the substrate 160 may undergo further back-end processing. Fig. 5D shows a dielectric film 170 deposited on top of the substrate 160. The dielectric film may fill the remainder of the cavity 162. Alternatively, a separate dielectric film may be deposited within the cavity 162 prior to the deposition of the dielectric film 170. For example, a SiO₂ or SiN material could fill the cavity 162. It is contemplated that SiN may be a preferable etch stop material for subsequent via etches carried out within the dielectric film 170.

Returning to Fig. 5D, the dielectric film 170 has been etched so that a portion 172 of the resistive layer 168 is exposed. A subsequent via-fill process may fill the portion 172 and establish an electrical coupling with the exposed portion of resistance layer 168.

Those skilled in the art will understand that changes and modifications may be made to these examples without departing from the true scope and spirit of the present invention, which is defined by the claims. Thus, the presented figures are intended to generally convey example arrangements of resistor and resistor capacitor structures. Although the figures generally illustrate a resistance layer as coupling two electrical contacts together, it should be understood that a resistance layer may be used to couple a plurality of electrical contacts together. Also, the term "contact" has been used to refer to inter-level electrical connections between front-end devices (e.g., MOS transistors, capacitors, etc.) and back-end interconnects and devices. On the other hand, the term "via" has been used to refer to inter-level electrical connections between back-end interconnects and devices. It should be understood, however, that "contacts" and "vias" may be interchangeably placed in a variety of locations in a dielectric layer and the figures and associated description should not be viewed as limiting.

Accordingly, the description of the present invention is to be construed as illustrative only and is for the purpose of teaching those skilled in the art the best mode of carrying out the invention. The details may be varied substantially without departing from the spirit of the invention, and the exclusive use of all modifications which are within the scope of the appended claims is reserved.

## Claims

1. A method for fabricating a resistor capacitor structure, the method comprising:
providing a substrate;
depositing a first layer on the substrate, wherein the first layer electrically couples a first electrical contact to a second electrical contact, and wherein the first layer serves as both a bottom plate and a resistive element of the resistor capacitor structure; and
depositing a second layer on top of the first layer, wherein the second layer comprises a dielectric material.

2. The method of claim 1, wherein the first layer has a sheet resistance of at least 5 kΩ/square.

3. The method of claim 1, further comprising depositing a third layer on top of the second layer, wherein the third layer comprises a conductive material that serves as a top plate of the resistor capacitor structure.

4. The method of claim 1, wherein the first layer comprises tantalum nitride (TaN).

5. The method of claim 4, wherein depositing the first layer comprises using a TaN sputter deposition process, and wherein a nitrogen (N₂) partial pressure of the deposition process is adapted to achieve a desired RC time of the resistor capacitor structure.

6. The method of claim 1, wherein the first layer comprises a material selected from the group consisting of chrome silicon (CrSi) and aluminum silicon nitride (AlSiN).

7. The method of claim 1, wherein forming the resistor capacitor structure comprises depositing a photoresist layer and etching away a portion of the stack comprising the first and second layers.

8. The method of claim 7, further comprising patterning the photoresist layer and etching the stack comprising the first and second layers in a single photolithographic iteration.

9. The method of claim 1, wherein forming the resistor capacitor structure comprises forming a cavity in the substrate and depositing the first and second layers in the cavity.
